# EUROPEAN PATENT APPLICATION

(11) **EP 4 796 944 A1**
(43) Date of publication of application: **26.08.2026**
(21) Application number: 24880055.9
(22) Date of filing: 14.10.2024
(51) Int. Cl.: G01R 31/52, G01R 31/389, G01R 31/382, G01R 31/385, G01R 31/392, G01R 31/36

(54) **METHOD FOR DETECTING INTERNAL SHORT CIRCUIT OF BATTERY AND APPARATUS THEREFOR**

(30) Priority: 18.10.2023 KR 20230139686
(71) Applicant: SK On Co., Ltd., Seoul 03161 (KR)
(72) Inventor: HWANG, Kyu Min, Daejeon 34124 (KR); JON, Ung, Daejeon 34124 (KR)
(74) Representative: Stolmár & Partner Patentanwälte PartG mbB
(86) International application number: PCT/KR2024/015500
(87) International publication number: WO 2025/084718

(57) **Abstract**

The present disclosure relates to a method and an apparatus for detecting an internal short circuit of a battery. A method for detecting an internal short circuit of a battery according to an embodiment of the present disclosure may include: acquiring a first time point voltage of at least one battery at a first time point after the battery enter a rest period; calculating a first time point effective capacity of the at least one battery based on a first state of charge (SOC), a state of health (SOH), and a battery initial capacity of the at least one battery at the first time point; calculating a second time point effective capacity of the at least one battery based on a second SOC, the SOH, and the battery initial capacity of the at least one battery at a second time point after the first time point; calculating an acting resistance of the at least one battery based on the first time point voltage, the first time point effective capacity, the second time point effective capacity, and an additional rest period time from the first time point to the second time point; and determining an internal short circuit of the at least one battery if the calculated acting resistance is less than a reference resistance value.

## Description

### [Technical Field]

The present disclosure relates to a method and an apparatus for detecting an internal short circuit of a battery.

### [Background Art]

In modern society, battery systems are playing an increasingly important role and are used in mobile electronic products, electric vehicles, renewable energy facilities, and various other application fields. In particular, the development and dissemination of high-capacity batteries for electric vehicles are receiving great attention in modern society, which emphasizes eco-friendliness and sustainability.

Although a battery with a high capacity provides a longer driving range, a longer usage time, and a larger energy storage capacity, the use of such a high-capacity battery may involve potential risks such as fire or explosion in an unstable environment.

As a method for preventing this, a technology for detecting an internal short circuit of a battery is one of the important technologies for early detection and prevention of problems occurring inside the battery, and an internal short circuit may be detected using changes in battery voltage and current without requiring additional equipment.

However, in the case of batteries that are gradually increasing in capacity, the technology for detecting an internal short circuit of a battery using changes in voltage and current has a problem in that it is difficult to detect a low-level internal short circuit due to the occurrence of noise and interference, and thus a technology for stably detecting an internal short circuit of a high-capacity battery is required.

### [Summary of Invention]

### [Problems to be Solved by Invention]

The present disclosure may provide a method and an apparatus for diagnosing an internal short circuit of a battery.

### [Means for Solving Problems]

According to an embodiment of the present disclosure, a method for detecting an internal short circuit of a battery may include: acquiring a first time point voltage of at least one battery at a first time point after the at least one battery enters a rest period; calculating a first time point effective capacity of the at least one battery based on a first state of charge (SOC), a state of health (SOH), and a battery initial capacity of the at least one battery at the first time point; calculating a second time point effective capacity of the at least one battery based on a second SOC, the SOH, and the battery initial capacity of the at least one battery at a second time point after the first time point; calculating an acting resistance of the at least one battery based on the first time point voltage, the first time point effective capacity, the second time point effective capacity, and an additional rest period time from the first time point to the second time point; and determining an internal short circuit of the at least one battery if the calculated acting resistance is less than a reference resistance value.

According to an embodiment, the first time point may be a time point determined while the rest period is maintained, and the second time point may be a time point when the rest period ends.

According to an embodiment, the acting resistance of the at least one battery may be calculated based on a mathematical equation configured to be proportional to at least one of the first time point voltage and the additional rest period time, and inversely proportional to a difference value between the first time point effective capacity and the second time point effective capacity.

According to an embodiment, the mathematical equation may be $acting resistance = \frac{first time point voltage}{first time point effective capacity - second time point effective capacity} ∗ additional rest period time$ .

According to an embodiment, the first time point may be preset to select a value corresponding to a value in a range from 30 minutes to 4 hours after entering the rest period, based on a temperature of the battery.

According to an embodiment, the SOH may be a value calculated in the calculating of the first time point effective capacity or a value calculated before the calculating of the first time point effective capacity.

According to an embodiment, the at least one battery may be configured in a unit of a cell, a module, or a pack.

According to an embodiment, the reference resistance value may be a value determined in a range from 10 ohms to 100 ohms.

According to an embodiment, the method for detecting an internal short circuit of a battery may further include: generating a guidance message for a cell or a module of the at least one battery where the internal short circuit has been determined; and transmitting the guidance message to a preset device.

According to an embodiment, the preset device may include at least one of a user device, a manufacturer device of the at least one battery, or a device in which the atleast one battery is mounted.

According to an embodiment of the present disclosure, an apparatus for detecting an internal short circuit of a battery may include: a voltage processing unit configured to acquire a first time point voltage of at least one battery at a first time point after the at least one battery enters a rest period; a capacity estimation unit configured to calculate a first time point effective capacity of the at least one battery based on a first state of charge (SOC), a state of health (SOH), and a battery initial capacity of the at least one battery at the first time point, and to calculate a second time point effective capacity of the at least one battery based on a second SOC, the SOH, and the battery initial capacity of the at least one battery at a second time point after the first time point; an acting resistance estimation unit configured to calculate an acting resistance of the at least one battery based on the first time point voltage, the first time point effective capacity, the second time point effective capacity, and an additional rest period time from the first time point to the second time point; and an internal short circuit determination unit configured to determine an internal short circuit of the at least one battery if the calculated acting resistance is less than a reference resistance value.

According to an embodiment, the voltage processing unit may determine the first time point while the rest period is maintained, and determine the second time point when the rest period ends.

According to an embodiment, the acting resistance estimation unit may calculate the acting resistance of the at least one battery based on a mathematical equation configured to be proportional to at least one of the first time point voltage and the additional rest period time, and inversely proportional to a difference value between the first time point effective capacity and the second time point effective capacity.

According to an embodiment, the mathematical equation may be $acting resistance = \frac{first time point voltage}{first time point effective capacity - second time point effective capacity} ∗ additional rest period time$ .

According to an embodiment, the first time point may be preset to select a value corresponding to a value in a range from 30 minutes to 4 hours after entering the rest period, based on a temperature of the battery.

According to an embodiment, the SOH may be a value calculated in the calculating of the first time point effective capacity or a value calculated before the calculating of the first time point effective capacity.

According to an embodiment, the at least one battery may be configured in a unit of a cell, a module, or a pack.

According to an embodiment, the reference resistance value may be a value determined in a range from 10 ohms to 100 ohms.

According to an embodiment, the apparatus for detecting an internal short circuit of a battery may further include an internal short circuit notifying unit configured to generate a guidance message for a cell or a module of the at least one battery where the internal short circuit has been determined, and to transmit the guidance message to a preset device.

According to an embodiment, the preset device may include at least one of a user device, a manufacturer device of the at least one battery, or a device in which the at least one battery is mounted.

### [Advantageous effects]

According to an embodiment of the present disclosure, a method and an apparatus for detecting an internal short circuit of a battery may accurately detect even a low-level internal short circuit regardless of battery capacity by detecting whether an internal short circuit of the battery has occurred based on a change in cell capacity.

Furthermore, according to an embodiment of the present disclosure, a method and an apparatus for detecting an internal short circuit of a battery may accurately detect an internal short circuit without requiring additional equipment by applying an acting resistance, which has versatility as an indicator for a change in cell capacity.

### [Brief Description of Drawings]

FIG. 1 is a diagram illustrating a configuration of an apparatus according to an embodiment.
FIG. 2 is a block diagram illustrating a detailed configuration of an apparatus according to an embodiment, classified according to function.
FIG. 3 is a flowchart illustrating a flow of an operation for detecting an internal short circuit of a battery in an apparatus according to an embodiment.
FIG. 4 is a flowchart illustrating an operation for transmitting information about an internal short circuit of a battery in an apparatus according to an embodiment.
FIG. 5 is a flowchart illustrating a detailed flow of an operation for detecting an internal short circuit of a battery in an apparatus according to an embodiment.

### [Mode for Carrying out Invention]

Hereinafter, the present disclosure will be described in detail with reference to the accompanying drawings. However, these are merely examples, and the present disclosure is not limited to the specific embodiments described as examples.

Although terms such as 'first' and 'second' are used to describe various elements, components, and/or sections, it is to be understood that these elements, components, and/or sections are not limited by these terms. These terms are only used to distinguish one element, component, or section from another. Thus, a first element, a first component, or a first section mentioned below may be a second element, a second component, or a second section within the technical spirit of the present disclosure.

The terminology used herein is for the purpose of describing embodiments and is not intended to be limiting of the present disclosure. In this specification, the singular forms include the plural forms unless the context clearly indicates otherwise. The terms "comprises" and/or "made of" used in the specification specify the presence of stated components, steps, operations, and/or elements, but do not preclude the presence or addition of one or more other components, steps, operations, and/or elements.

Unless otherwise defined, all terms (including technical and scientific terms) used herein may be used in a sense that can be commonly understood by one of ordinary skill in the art to which this disclosure belongs. In addition, terms defined in commonly used dictionaries are not to be interpreted in an idealized or overly formal sense unless expressly so defined.

The present disclosure describes a method and an apparatus for detecting an internal short circuit of a battery. More specifically, a method and an apparatus for detecting an internal short circuit based on a change in capacity of the battery may be described.

A battery according to various embodiments may be configured to include a secondary battery that may be charged or discharged multiple times, such as a lithium iron phosphate (LiFePO4) battery or a lithium-ion battery.

Here, a battery is configured to include at least one cell, and may be configured as a battery pack or a battery module. For example, a battery module is configured to include two or more cells, and a battery pack may be configured to include at least one battery module.

Based on this, a battery may be configured with at least one cell, at least one module, or at least one pack.

In describing various embodiments, an operation for detecting an internal short circuit of a battery may be described as an operation for detecting an internal short circuit of a battery configured in units of a cell, a module, or a pack.

An apparatus for detecting an internal short circuit of a battery (hereinafter, an apparatus 100) may be configured as a battery management system (BMS) or a part thereof.

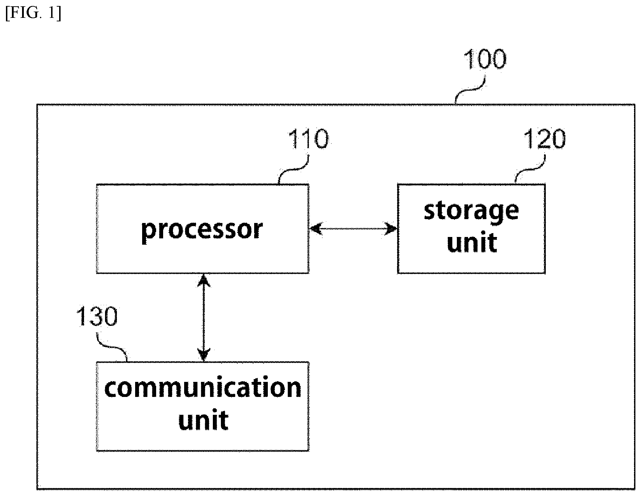

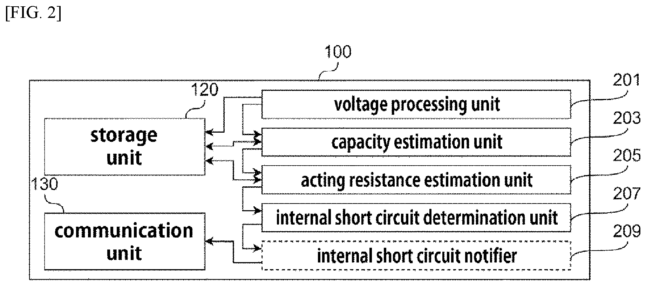

FIG. 1 is a diagram illustrating a configuration of an apparatus according to an embodiment. FIG. 2 is a block diagram illustrating a detailed configuration of an apparatus according to an embodiment, classified according to function.

First, referring to FIG. 1, the apparatus 100 may be configured to include a processor 110, a storage unit 120, and a communication unit 130.

The processor 110 may process data received from a battery connected to the apparatus 100 through at least one program (e.g., an application, a tool, a plug-in, software, etc., hereinafter referred to as a battery diagnosis program).

In this case, the battery diagnosis program may be stored in the storage unit 120 of the apparatus 100 and/or in a storage unit of an external device connected to the apparatus 100.

In addition, the processor 110 may transmit and receive data to and from components of the apparatus 100 or an external device via the communication unit 130, and may process the transmitted and received data. In this case, the processor 110 may process the data acquired through the communication unit 130 based on an identified user.

For example, the processor 110 may identify a user through a user device and/or user information connected via the communication unit 130 and perform an operation according to a control command input therethrough. In addition, the processor 110 may transmit information acquired while performing the operation according to the control command to a preset device (e.g., a user device).

To this end, the processor 110 may also check a user's authority through an operation of identifying the user.

In performing the battery internal short circuit detection operation of the apparatus 100, its detailed components may be distinguished based on the operations and functions performed.

For example, as illustrated in FIG. 2, the apparatus 100 may be configured to include a voltage processing unit 201, a capacity estimation unit 203, an acting resistance estimation unit 205, and an internal short circuit determination unit 207. In addition, the apparatus 100 may be configured to further include an internal short circuit notifying unit 209.

In this case, at least some of the voltage processing unit 201, the capacity estimation unit 203, the acting resistance estimation unit 205, the internal short circuit determination unit 207, and the internal short circuit notifying unit 209 may be included as components of the processor 110. Based on this, the apparatus 100 may be configured to include at least one processor.

The storage unit 120 may store various data processed by at least one component of the apparatus 100 (e.g., the processor 110 or the communication unit 130, etc.). The data may include, e.g., a program for processing a control command, data processed through the program, or related input data and output data.

The storage unit 120 may include an algorithm for processing a control command, the algorithm including at least one of an artificial neural network algorithm, a blockchain algorithm, a deep learning algorithm, a regression analysis algorithm, and related mechanisms, operators, language models, and big data.

The storage unit 120 may include data for confirming and processing designated controls and operations through signals received via each element included in an input/output unit.

The operations described with reference to the storage unit 120 are processed by the processor 110, and data for processing related operations, data being processed, processed data, preset data, or the like may be stored in the storage unit 120 as a database.

Data stored in the storage unit 120 may be changed, modified, or deleted, or new data may be generated by the processor 110 based on a user input from an identified user.

Device setting information of the apparatus 100 may be stored in the storage unit 120. The device setting information may be setting information for at least a part of the functions and services provided by the apparatus 100.

The storage unit 120 may be configured to include a volatile memory, a non-volatile memory, or a computer-readable recording medium as such. In this case, a computer program for the apparatus 100 to perform operations based on various embodiments may be stored in the computer-readable recording medium.

The communication unit 130 may support establishment of a wired communication channel, establishment of a wireless communication channel, and performance of communication through the established communication channel between the apparatus 100 and at least one other device (e.g., a user device or a server).

The communication unit 130 may operate dependently or independently of the processor 110 and may be configured to include one or more communication processors that support wireless communication or wired communication.

According to an embodiment, when the communication unit 130 supports wireless communication, it may include at least some communication modules among a wireless communication module, e.g., a cellular communication module, a short-range wireless communication module, and a global navigation satellite system (GNSS) communication module.

When the communication unit 130 supports wired communication, it may include at least some communication modules among a wired communication module, e.g., a local area network (LAN) communication module, or a power line communication module, a controller area network (CAN) communication module, a serial peripheral interface (SPI) communication module, and a programmable logic controller (PLC) communication module.

However, the present disclosure is not limited thereto, and the communication unit 130 may be configured to communicate with an external device wiredly or wirelessly through a short-range communication network such as Bluetooth, Bluetooth Low Energy (BLE), WiFi, WiFi direct, infrared data association (IrDA), ZigBee, UWB, Radio Frequency (RF), or a long-range communication network such as a cellular network, the internet, or a computer network (e.g., LAN or WAN).

Various types of communication modules constituting the communication unit 130 may be integrated into a single component (e.g., a single chip) or may be implemented as a plurality of separate components (e.g., a plurality of chips).

In addition, the apparatus 100 may be configured to further include or be connected to an input/output unit. The input/output unit may be configured to include an input unit and/or an output unit.

The input/output unit may include or be connected to at least one of an input unit (not shown) for inputting data, such as a keyboard, a mouse, or a touch pad, and an output unit (not shown) for outputting data, such as a display unit (e.g., a display), a speaker, or a driving unit.

According to various embodiments, the apparatus 100 or the user device may include at least some of the functions within the scope of all information and communication devices, including a mobile communication terminal, a multimedia terminal, a wired terminal, a fixed terminal, and an internet protocol (IP) terminal.

The apparatus 100, as an apparatus for processing control commands, may be configured to include at least some functions of a workstation or a large-capacity database, or to be connected through communication.

The user device connected to the apparatus 100 may be exemplified by a mobile phone, a personal computer (PC), a portable multimedia player (PMP), a mobile internet device (MID), a smartphone, a tablet PC, a phablet PC, a notebook, or the like.

According to various embodiments, the user device may be described as a device that connects and communicates with the apparatus 100. For example, although not described through the drawings, the user device may be a user's smartphone that transmits a link generated by the apparatus 100 in relation to a vehicle.

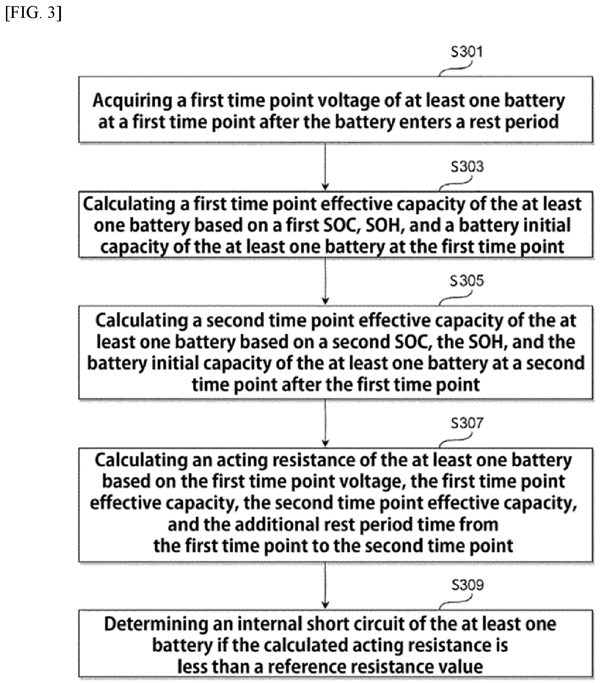

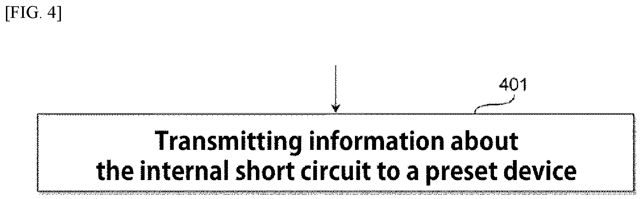

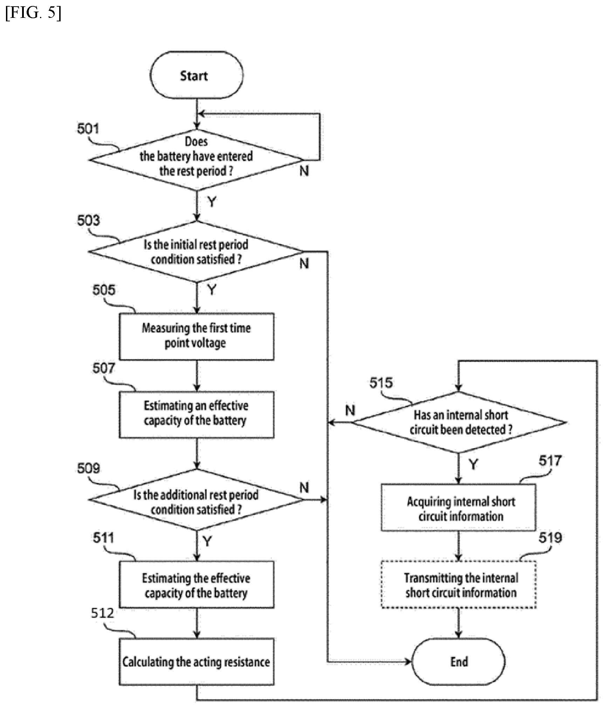

Hereinafter, an operation in which the apparatus 100 detects an internal short circuit of a vehicle's battery may be described with reference to FIGS. 3 to 5. Accordingly, FIG. 3 is a flowchart illustrating a flow of an operation for detecting an internal short circuit of a battery in an apparatus according to an embodiment. FIG. 4 is a flowchart illustrating an operation for transmitting information about an internal short circuit of a battery in an apparatus according to an embodiment. FIG. 5 is a flowchart illustrating a detailed flow of an operation for detecting an internal short circuit of a battery in an apparatus according to an embodiment.

First, an operation in which the apparatus 100 detects an internal short circuit of a battery may be described with reference to FIGS. 3 and 5.

In operation S301, the voltage processing unit 201 may acquire a first time point voltage of at least one battery at a first time point after the battery enters a rest period. Describing in more detail with reference to FIG. 5, the voltage processing unit 201 may determine 501 whether the battery has entered the rest period.

According to an embodiment, the voltage processing unit 201 may determine that the battery has entered the rest period when it confirms that the operation of a load device to which the battery is connected has stopped. More specifically, the voltage processing unit 201 may measure a current flow of the battery at every preset time unit, and may determine that the battery has entered the rest period when it confirms that the current flow has stopped (or a current flow less than a preset current value (unit: ampere, A) is measured).

For example, the voltage processing unit 201 may determine that the battery has entered the rest period when it confirms that an ignition of a vehicle to which the battery is connected has been turned off.

In addition, the voltage processing unit 201 may determine that the battery has entered the rest period when it confirms that there is no change in the battery's current even after a preset time has elapsed from a time point when it confirmed that the current flow of the battery has stopped (or a current flow less than a preset current value (A) is measured), or that the operation of the load device to which the battery is connected has stopped.

On the other hand, the voltage processing unit 201 may determine that an initial rest period condition is not satisfied if the rest period ends before a first time is reached while maintaining the rest period of the battery.

If the initial rest period condition is not satisfied, the voltage processing unit 201 may terminate the embodiment of FIG. 3 (e.g., the operation of detecting an internal short circuit of the battery).

Here, the case where the rest period ends is a case where the rest period was not maintained for the first time, and according to an example, in the case of a vehicle equipped with a battery, it may be a case where a load discharge is performed, such as turning on the ignition, before the first time has passed from the time point when the battery entered the rest period.

On the other hand, if the voltage processing unit 201 confirms that the battery has not entered the rest period, it may repeatedly perform the operation of determining whether the battery has entered the rest period (501). However, the present disclosure is not limited thereto, and if the voltage processing unit 201 confirms that the battery has not entered the rest period, it may also terminate the embodiment of FIG. 5.

Assuming again that the battery has entered the rest period, if the voltage processing unit 201 confirms that the battery has entered the rest period, it may measure at least some of a battery voltage, a current, and a temperature in the rest period state. Here, the voltage processing unit 201 may determine the voltage measured in the rest period state of the battery as an open circuit voltage (OCV).

Here, the voltage processing unit 201 may measure an initial voltage, a current, or a battery temperature for at least a part of the battery, e.g., at least one cell or at least one module.

Subsequently, the voltage processing unit 201 may determine 503 whether a battery state satisfies an initial rest period condition. For example, the initial rest period condition may be set to determine whether a first time has elapsed since the time point when the battery entered the rest period (whether the rest period has been maintained for the first time). Here, the first time may be determined as a specific value (time) preset in a range from 30 minutes to 4 hours according to the battery temperature.

To this end, first time determination data, in which a rest period time corresponding to at least one battery temperature is set, may be stored in the storage unit 120. According to an example of the first time determination data, the first time may be set to 30 minutes for at least one temperature in a range of room temperature (e.g., 20 degrees celsius to 25 degrees celsius), or the first time may be set to 2 hours for 0 degrees celsius. However, the present disclosure is not limited thereto, and the rest period time corresponding to the battery temperature in the first time determination data may be changed and set.

Based on this, the voltage processing unit 201 may set the rest period time corresponding to the battery temperature at the time point when the battery entered the rest period as the first time. And, the voltage processing unit 201 may determine that the initial rest period condition is satisfied when the first time is reached while the rest period of the battery is maintained.

The voltage processing unit 201 may determine the time point at which the initial rest period condition is satisfied as the first time point, and may measure 505 the battery voltage at the first time point. In this case, the voltage processing unit 201 may measure the battery voltage (e.g., the first time point voltage) measured at the first time point in the rest period state as an open circuit voltage (OCV).

On the other hand, the voltage processing unit 201 may determine that the initial rest period condition is not satisfied if the rest period ends before the first time is reached while the rest period of the battery is maintained.

If the initial rest period condition is not satisfied, the voltage processing unit 201 may terminate the embodiment of FIG. 3 (e.g., the operation of detecting an internal short circuit of the battery).

Here, the case where the rest period ends is a case where the rest period was not maintained for the first time, and according to an example, in the case of a vehicle equipped with a battery, it may be a case where a load discharge is performed, such as turning on the ignition, before the first time has passed from the time point when the battery entered the rest period.

Subsequently, in operation S303 of FIG. 3, the capacity estimation unit 203 may calculate a first time point effective capacity of the at least one battery based on a first state of charge (SOC), a state of health (SOH), and a battery initial capacity of the at least one battery for the first time point.

Describing in more detail with reference to FIG. 5, the voltage processing unit 201 and the capacity estimation unit 203 may estimate 507 an effective capacity of the battery at the first time point (a first time point effective capacity).

More specifically, the voltage processing unit 201 may estimate at least one of the SOC and the SOH of the battery based on the first time point voltage measured at the first time point.

In this case, the voltage processing unit 201 may predict a first time point SOC based on the first time point voltage. To this end, an OCV-SOC conversion table for the battery may be in a state of being stored in the storage unit 120.

In addition, the voltage processing unit 201 may calculate the SOH of the battery based on at least some of the first time point voltage and the first time point SOC. However, the present disclosure is not limited thereto, and the voltage processing unit 201 may acquire the last (or most recent) stored SOH from the storage unit 120. Here, the last stored SOH may be a value calculated by the voltage processing unit 201 before the operation S303 of calculating (or estimating) the first time point effective capacity.

The capacity estimation unit 203 may calculate the effective capacity of the battery (the first time point effective capacity) based on the first time point voltage and the first time point SOC acquired as described above, and the battery SOH.

According to an embodiment, the capacity estimation unit 203 may calculate the effective capacity of the battery at a specific time point as a product of a total capacity (or initial capacity) of the battery, the SOC at the specific time point, and the SOH.

Based on this, and described in more detail, the capacity estimation unit 203 may calculate the first time point effective capacity of the battery based on the total capacity (or initial capacity) of the battery, the first time point SOC, and the SOH.

For example, assuming a total battery capacity of 200 Ah, a first time point SOC of 90%, and an SOH of 50%, the capacity estimation unit 203 may calculate a first time point effective capacity of 90 Ah for the battery.

According to various embodiments, the capacity estimation unit 203 may calculate the first time point effective capacity for at least a part of the battery, e.g., at least one cell or at least one module.

Subsequently, again in operation S305 of FIG. 3, the capacity estimation unit 203 may calculate a second time point effective capacity of the at least one battery based on a second SOC, the SOH, and the battery initial capacity of the at least one battery for a second time point after the first time point.

Describing in more detail with reference to FIG. 5, the voltage processing unit 201 may determine 509 whether the battery state satisfies an additional rest period condition. For example, the additional rest period condition may be set to determine whether a second time has elapsed from the first time point (whether the rest period has been maintained for the second time). Here, the second time may be determined as the time from the first time point until the time point when the rest period ends (the second time point).

According to an embodiment, a minimum time may be set for the second time. In this case, the voltage processing unit 201 may determine that the additional rest period condition is not satisfied if the rest period ends before a minimum time (minimum additional rest period time) is reached while the rest period is maintained after the first time point.

According to an embodiment, in the case of a vehicle equipped with a battery, if a load discharge is performed, such as turning on the ignition, before a minimum additional rest period time of 1 hour has passed from the first time point, the voltage processing unit 201 may terminate the embodiment of FIG. 3 (e.g., the operation of detecting an internal short circuit of the battery).

Here, the minimum additional rest period time of 1 hour is for an example, and may be changed and set.

The voltage processing unit 201 may determine that the additional rest period condition is satisfied when the minimum time is reached while the rest period of the battery is maintained after the first time point, and may count an additional rest period time until the time point (the second time point) when the rest period ends (or has ended) after the first time point.

Here, the second time point at which the rest period ends (or has ended) may be defined as a time point at which load discharge has not started.

The voltage processing unit 201 may determine the time point at which the rest period ends as the second time point as described above, and when the rest period ends, it may estimate 511 the effective capacity of the battery at the second time point (the second time point effective capacity).

More specifically, the voltage processing unit 201 may measure the battery voltage for the second time point, and may estimate at least one of the SOC and the SOH of the battery based on the measured battery voltage (e.g., a second time point voltage).

In this case, the voltage processing unit 201 may determine the battery voltage (e.g., the second time point voltage) measured at the second time point in the rest period state as an open circuit voltage (OCV), and may predict a second time point SOC based on the second time point voltage.

In addition, the voltage processing unit 201 may calculate the SOH of the battery based on at least some of the first time point voltage, the second time point voltage, and the second time point SOC. However, the present disclosure is not limited thereto, and the voltage processing unit 201 may acquire the last (or most recent) stored SOH from the storage unit 120.

The capacity estimation unit 203 may calculate the effective capacity of the battery (the second time point effective capacity) based on the second time point voltage and the second time point SOC acquired as described above, and the battery SOH.

More specifically, the capacity estimation unit 203 may calculate the second time point effective capacity of the battery based on the total capacity (or initial capacity) of the battery, the second time point SOC, and the SOH.

For example, assuming a total battery capacity of 200 Ah, a first time point SOC of 86%, and an SOH of 50%, the capacity estimation unit 203 may calculate a second time point effective capacity of 86 Ah for the battery.

According to various embodiments, the capacity estimation unit 203 may calculate the second time point effective capacity for at least a part of the battery, e.g., at least one cell or at least one module.

Subsequently, again in operation S307 of FIG. 3, the acting resistance estimation unit 205 may calculate an acting resistance (unit: ohm) of the at least one battery based on the first time point voltage, the first time point effective capacity, the second time point effective capacity, and the additional rest period time from the first time point to the second time point.

More specifically, the acting resistance estimation unit 205 may calculate 512 the acting resistance of the at least one battery based on Equation (1), which is configured to be proportional to at least some of the first time point voltage and the additional rest period time, and inversely proportional to a difference value between the first time point effective capacity and the second time point effective capacity.$acting resistance = \frac{first time point voltage}{first time point effective capacity - second time point effective capacity} ∗ additional rest period time$

For example, assuming that the first time point voltage is 4v, the first time point effective capacity is 90 Ah, the second time point effective capacity is 86 Ah based on the examples described above, and the additional rest period time is 10 hours, the acting resistance estimation unit 205 may calculate the acting resistance for the battery as 10 ohms.

According to various embodiments, the acting resistance estimation unit 205 may calculate the acting resistance for at least a part of the battery, e.g., at least one cell or at least one module.

Subsequently, in operation S309 of FIG. 3, the internal short circuit determination unit 207 may determine an internal short circuit of the at least one battery if the calculated acting resistance is less than a reference resistance value.

Describing in more detail with reference to FIG. 5, the internal short circuit determination unit 207 may determine 515 whether an internal short circuit has occurred by comparing the calculated acting resistance with a preset reference resistance value.

According to an embodiment, the internal short circuit determination unit 207 may determine that an internal short circuit has occurred in the battery if the calculated acting resistance is smaller than the reference resistance value. Here, the reference resistance value may be in a state of being preset to a value within a range of 10 ohms to 100 ohms.

For example, as described above, assuming that the acting resistance of the battery is 10 ohms and the reference resistance value is 50 ohms, the internal short circuit determination unit 207 may determine that an internal short circuit has occurred in the battery.

On the other hand, if the calculated battery acting resistance is equal to or greater than the reference resistance value, the internal short circuit determination unit 207 may determine that an internal short circuit has not occurred in the battery.

According to various embodiments, the internal short circuit determination unit 207 may determine whether an internal short circuit has occurred for at least a part of the battery, e.g., at least one cell or at least one module.

When the internal short circuit determination unit 207 detects an internal short circuit that has occurred in the battery, it may acquire 517 internal short circuit information. According to an embodiment, the internal short circuit determination unit 207 may acquire information about a cell, a module, or a pack in which an internal short circuit has occurred (or is suspected).

For example, the internal short circuit determination unit 207 may acquire battery information including at least some information among battery pack, module, or cell unique information, effective capacity, SOC, and SOH.

In this case, the internal short circuit determination unit 207 may determine a battery risk level based on the acting resistance value generated for a cell or a module. For example, the internal short circuit determination unit 207 may determine a risk level for at least a part of the cell or module based on the acting resistance value generated in the cell or module. Here, the risk level may be in a state of being classified into a plurality of grades, such as stable or dangerous.

On the other hand, if the internal short circuit determination unit 207 determines that no internal short circuit has occurred in the battery, it may terminate the embodiment of FIG. 3 (e.g., the operation of detecting an internal short circuit of the battery).

According to various embodiments, as illustrated in FIG. 4, in operation 401, the internal short circuit notifying unit 209 may transmit information about the internal short circuit to a preset device.

For example, the internal short circuit notifying unit 209 may generate a guidance message including at least some of information about the cell or module in which the internal short circuit occurred and risk level information, and may transmit 519 the generated guidance message to a preset device (e.g., a vehicle's infotainment system, a user's mobile phone, a vehicle maintenance shop server, etc.).

According to the above description, it is described that the operation of the internal short circuit notifying unit 209 transmitting 401 information about the internal short circuit to the preset device is performed after the internal short circuit determination unit 207 performs the operation of determining S309 the internal short circuit of at least one battery. However, the present disclosure is not limited thereto, and the internal short circuit notifying unit 209 may transmit 401 the information about the internal short circuit to the preset device when requested to transmit information about the internal short circuit of the battery from the user device, separately from the operation of FIG. 3.

As described above, the method and apparatus for detecting an internal short circuit of a battery may accurately detect even a low-level internal short circuit regardless of the battery capacity by detecting whether a battery internal short circuit has occurred based on a change in cell capacity.

According to various embodiments, the method and apparatus for detecting an internal short circuit of a battery may accurately detect an internal short circuit without requiring additional equipment by applying an acting resistance, which has versatility as an indicator for a change in cell capacity.

According to the detailed description, the functions of the various embodiments described as being performed by the apparatus 100 are operations processed through the processor 110 of the apparatus 100, and may be performed by being organically connected with components of the apparatus 100 or another device connected to the apparatus 100.

The above description is merely an example applying the principles of the present disclosure, and other configurations may be further included without departing from the scope of the present disclosure.

## Claims

1. A method for detecting an internal short circuit of a battery, comprising:
acquiring a first time point voltage of at least one battery at a first time point after the at least one battery enters a rest period;
calculating a first time point effective capacity of the at least one battery based on a first state of charge (SOC), a state of health (SOH), and a battery initial capacity of the at least one battery at the first time point;
calculating a second time point effective capacity of the at least one battery based on a second SOC, the SOH, and the battery initial capacity of the at least one battery at a second time point after the first time point;
calculating an acting resistance of the at least one battery based on the first time point voltage, the first time point effective capacity, the second time point effective capacity, and an additional rest period time from the first time point to the second time point; and
determining an internal short circuit of the at least one battery when the calculated acting resistance is less than a reference resistance value.

2. The method for detecting an internal short circuit of a battery according to claim 1, wherein the first time point is a time point determined while the rest period is maintained, and the second time point is a time point when the rest period ends.

3. The method for detecting an internal short circuit of a battery according to claim 1, wherein the acting resistance of the at least one battery is calculated based on a mathematical equation, wherein the acting resistance is proportional to at least one of the first time point voltage and the additional rest period time, and is inversely proportional to a difference value between the first time point effective capacity and the second time point effective capacity.

4. The method for detecting an internal short circuit of a battery according to claim 3, wherein the mathematical equation is: $acting resistance = \frac{first time point voltage}{first time point effective capacity - second time point effective capacity} ∗ additional rest period time .$

5. The method for detecting an internal short circuit of a battery according to claim 1 to 4, wherein the first time point is preset to select a value corresponding to a value in a range from 30 minutes to 4 hours after entering the rest period, based on a battery temperature.

6. The method for detecting an internal short circuit of a battery according to claim 1 to 4, wherein the SOH is a value calculated in the calculating of the first time point effective capacity or a value calculated before the calculating of the first time point effective capacity.

7. The method for detecting an internal short circuit of a battery according to claim 1 to 4, wherein the at least one battery is configured in a unit of a cell, a module, or a pack.

8. The method for detecting an internal short circuit of a battery according to claim 1 to 4, wherein the reference resistance value is a value determined within a range of 10 ohms to 100 ohms.

9. A method for detecting an internal short circuit of a battery, further comprising: generating a guidance message for a cell or a module of the at least one battery where the internal short circuit has been determined; and transmitting the guidance message to a preset device.

10. The method for detecting an internal short circuit of a battery according to claim 9, wherein the preset device comprises at least one of a user device, a manufacturer device of the at least one battery, or a device in which the at least one battery is mounted.

11. An apparatus for detecting an internal short circuit of a battery, comprising:
a voltage processing unit configured to acquire a first time point voltage of at least one battery at a first time point after the at least one battery enters a rest period;
a capacity estimation unit configured to calculate a first time point effective capacity of the at least one battery based on a first state of charge (SOC), a state of health (SOH), and a battery initial capacity of the at least one battery at the first time point, and to calculate a second time point effective capacity of the at least one battery based on a second SOC, the SOH, and the battery initial capacity of the at least one battery at a second time point after the first time point;
an acting resistance estimation unit configured to calculate an acting resistance of the at least one battery based on the first time point voltage, the first time point effective capacity, the second time point effective capacity, and an additional rest period time from the first time point to the second time point; and
an internal short circuit determination unit configured to determine an internal short circuit of the at least one battery when the calculated acting resistance is less than a reference resistance value.

12. The apparatus for detecting an internal short circuit of a battery according to claim 11, wherein the voltage processing unit is further configured to determine the first time point while the rest period is maintained, and to determine the second time point when the rest period ends.

13. The apparatus for detecting an internal short circuit of a battery according to claim 11, wherein the acting resistance estimation unit is configured to calculate the acting resistance of the at least one battery based on a mathematical equation, wherein the acting resistance is proportional to at least one of the first time point voltage and the additional rest period time, and is inversely proportional to a difference value between the first time point effective capacity and the second time point effective capacity.

14. The apparatus for detecting an internal short circuit of a battery according to claim 13, wherein the mathematical equation is: $acting resistance = \frac{first time point voltage}{first time point effective capacity - second time point effective capacity} ∗ additional rest period time$

15. The apparatus for detecting an internal short circuit of a battery according to claim 11 to 14, wherein the first time point is preset to select a value corresponding to a value in a range from 30 minutes to 4 hours after entering the rest period, based on a battery temperature.

16. The apparatus for detecting an internal short circuit of a battery according to claim 11 to 14, wherein the SOH is a value calculated in the calculating of the first time point effective capacity or a value calculated before the calculating of the first time point effective capacity.

17. The apparatus for detecting an internal short circuit of a battery according to claim 11 to 14, wherein the at least one battery is configured in a unit of a cell, a module, or a pack.

18. The apparatus for detecting an internal short circuit of a battery according to claim 11 to 14, wherein the reference resistance value is a value determined within a range of 10 ohms to 100 ohms.

19. A method for detecting an internal short circuit of a battery,, further comprising: an internal short circuit notifying unit configured to generate a guidance message for a cell or a module of the at least one battery where the internal short circuit has been determined, and to transmit the guidance message to a preset device.

20. The apparatus for detecting an internal short circuit of a battery according to claim 19, wherein the preset device comprises at least one of a user device, a manufacturer device of the at least one battery, or a device in which the at least one battery is mounted.
